# EUROPEAN PATENT SPECIFICATION

(11) **EP 0 360 985 B1**
(45) Date of publication and mention of the grant of the patent: **25.01.1995**
(21) Application number: 89111639.4
(22) Date of filing: 27.06.1989
(51) Int. Cl.: H05K 13/04, H05K 13/02

(54) **Electronic parts engaging apparatus**
Elektronischen Bauelemente ergreifendes Gerät
Appareil de préhension de composants électroniques

(30) Priority: 29.06.1988 JP 161605/88; 25.07.1988 JP 184963/88; 25.07.1988 JP 184966/88
(43) Date of publication of application: 04.04.1990
(73) Proprietor: MATSUSHITA ELECTRIC INDUSTRIAL CO., LTD., Kadoma-shi, Osaka-fu, 571 (JP)
(72) Inventor: Izumi, Yasuo, Ikoma-shi Nara-ken (JP); Ishimoto, Kazumi, Katano-shi Osaka-fu (JP); Makino, Yutaka, Kobe-shi Hyogo-ken (JP)
(74) Representative: Eisenführ, Speiser & Partner

(56) References cited:
- EP-A- 0 155 512
- EP-A- 0 213 206

## Description

The invention relates to an electronic part mounting head comprising a suction nozzle made of light transmitting material for holding an electronic part, a recognition means including a first light ray applying means for applying light rays through the suction nozzle for recognizing the electronic part through the suction nozzle. Furthermore, the invention also concerns an electronic parts mounting apparatus comprising an electronic parts mounting head according to the invention.

Conventionally, in order to mount electronic parts on a circuit basic plate, a bonding agent is applied on the electronic parts mounting position of the circuit basic plate and also, solder for reflowing use is applied on the electrodes. The electronic parts to be engaged with in the parts feeding portion are held by a suction nozzle. The electronic parts are carried to the mounting position of the circuit basic plate for the mounting operation and are temporarily fixed with a bonding agent. After the engagement of all the electronic parts with respect to the circuit basic plate is completed, the circuit basic plate is inserted into the reflowing furnace to reflow the solder for the reflowing use. The electronic parts are finally secured with the solder and also, the electronic connection is effected. As an alternative solution the circuit basic plate with the electronic parts being temporarily secured with the bonding agent is dipped in a solder cell so as to solder-connect the electronic parts with the electrodes of the circuit basic plate.

It is to be noted that there excist various methods of temporarily securing the electronic parts:
(1) After the coating of the bonding agent on the basic plate, ultraviolet rays or the like are applied to improve the adherence of the bonding agent. The parts are engaged to effect a temporary fixing operation.
(2) After the coating of the bonding agent on the basic plate, the electronic parts are engaged. Ultraviolet rays or the like are applied on the bonding agent so as to effect a temporary fixing operation.

Generally, the latter is superior in the binding force of the parts. But in the case of the former, the electronic parts do not move, with a problem that the parts move in the case of the latter.

Namely, there is a problem that the parts move before the application of the ultraviolet rays, during the carrying operation of the basic plate, because an apparatus for applying ultraviolet rays, or the like are provided separately from the parts mounting apparatus.

As a result, the handling operation such as carrying operation of the basic plate, or the like is difficult to effect, thus resulting in inferior operationality.

Furthermore, a step of engaging the electronic parts with the circuit basic plate is required to temporarily secure them with the bonding agent, and a step of inserting the circuit basic plate into a reflowing furnace so as to actually secure the electronic parts onto the circuit basic plate, with a problem that the productivity is lower.

From EP-A-213 206 an apparatus for detecting the holding position of electronic parts in an electronic parts mounting apparatus is known, in which a recognition means including a light source for applying light through a suction nozzle of the mounting head and for recognizing the electronic part through the suction nozzle is known.

It is an essential object of the present invention to provide an electronic parts mounting head which is capable of temporarily securing electronic parts without moving them so as to improve the stability of the positions of the electronic parts for the actual fixing operation. The mounting of the electronic parts and the actual fixing operation should preferably take place in one step.

Another object of the present invention is to provide an electronic parts mounting apparatus comprising an electronic parts mounting head according to the first aspect of the invention, which is capable of automatically inputting parts data of the parts feed position without the problem of causing errors if wrong types of parts are fed. Moreover, it is an object of the present invention to hold the absorption nozzle, or a light transmitting plate of it, free from dust, filth etc. so as to prevent recognition errors.

According to the invention as claimed in claim 1, an electronic parts mounting head as defined above is characterized by a second light ray applying means which is adapted to be selectively positioned at the mounting head for securing the electronic part sucked to the suction nozzle to a circuit base plate.

Preferable embodiments, as well as an electronic parts mounting apparatus comprising an electronic parts mounting head as defined, can be taken from the dependent claims.

These and other objects and features of the present invention will become apparent from the following description taken in conjunction with the preferred embodiment thereof with reference to the accompanying drawings, in which;
Fig. 1 is a sectional view of an electronic parts mounting apparatus in a first embodiment of the present invention;
Fig. 2 is a view showing a mounting operation thereof;
Fig. 3 is a perspective view showing the application of ultraviolet rays;
Fig. 4 is a sectional view of an electronic part mounting apparatus in a second embodiment of the present invention;
Fig. 5 is a view of an electronic parts mounting apparatus in a third embodiment of the present invention;
Fig. 6 is a perspective view for illustrating the operation during an inputting operation of parts data;
Fig. 7 (a), (b), (c), (d) are plan views showing examples of marks given to the parts;
Fig. 8 is a block diagram of the electronic parts mounting apparatus;
Fig. 9 is a flow chart of the parts data inputting operation;
Fig. 10 is a perspective view of the essential portions of the parts feed portion in a fourth embodiment;
Fig. 11 is a flow chart of the parts mounting operation;
Fig. 12 is a whole construction view of a fifth embodiment of the present invention;
Fig. 13 is a sectional view of an ultrasonic wave washing cell,
Fig. 14 is a perspective view showing a washing operation;
Fig. 15 (a) is a plan view showing a condition of the absorption nozzle which needs cleaning; and
Fig. 15 (b) is a sectional view thereof.

Before the description of the present invention proceeds, it is to be noted that like parts are designated by like reference numerals throughout the accompanying drawings.

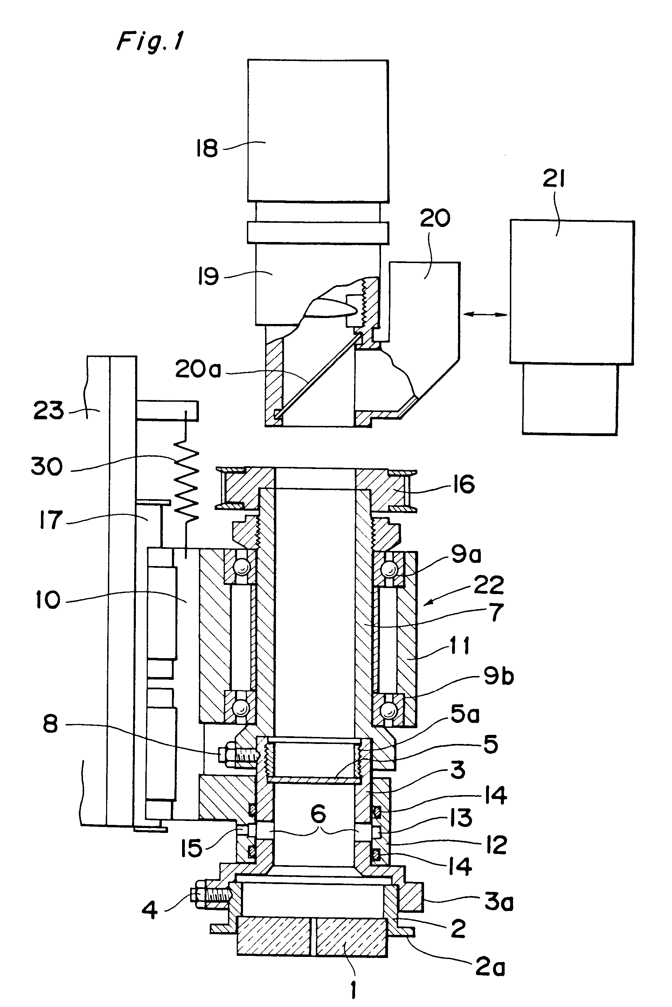

Referring now to the drawings, there is shown in Fig. 1 a suction nozzle 1 made of a light transmitting material by a nozzle holder 2, which is engaged with the lower end portion of a suction drum 3 and also, is engaged by a mounting fixture 4 so that the exchange may be effected with one touch in accordance with the size of the electronic parts to be mounted. The top end portion of the suction drum 3 is closed by a light transmitting plate 5, with suction openings being formed on the peripheral side wall. Stationary nuts 5a are used for the light transmitting plate 5. The top end portion of the suction drum 3 is engaged with the lower end portion of a rotary drum 7, and also, is engaged by a mounting fixture 8 so that it may be easily replaced when the interior of the suction drum 3 has been fouled.

The rotary drum 7 is rotatably supported by a support drum portion 11 disposed on an elevating member 10 through bearings 9a, 9b provided on the outer periphery of the upper portion and the lower portion thereof. Also, a suction outer drum 12 provided on the elevating member 10 is engaged with the outer periphery of the suction drum 3. A ring-shaped groove 13 is formed opposite to a suction opening on the inner periphery of the suction outer periphery, with O rings 14 for sealing being disposed on the both sides thereof. Also, the suction opening 15 to be connected to a suction source not shown is open to the ring-shaped groove 13.

A pulley 16 is secured to the upper end portion of the rotary drum 7 and is rotatably driven by a drive source not shown. Also, the elevating member 10 may rise, fall along a guide 17 and is elastically supported by a moving table 23 through a spring 30.

A recognition means or camera 18 is disposed for its possible movement between the same axial center position above the rotary drum 7 and a waiting position sideways thereof. A half mirror 20a is disposed in the lower portion of the optical mirror drum 19 so that the illumination light from an illumination equipment 20 disposed on the side portion is adapted to be applied towards the suction nozzle 1.

An ultraviolet applying apparatus 21, selectively with the recognition camera 18, is movable between the same axial center position above the rotary drum 7 and the waiting position sideways thereof.

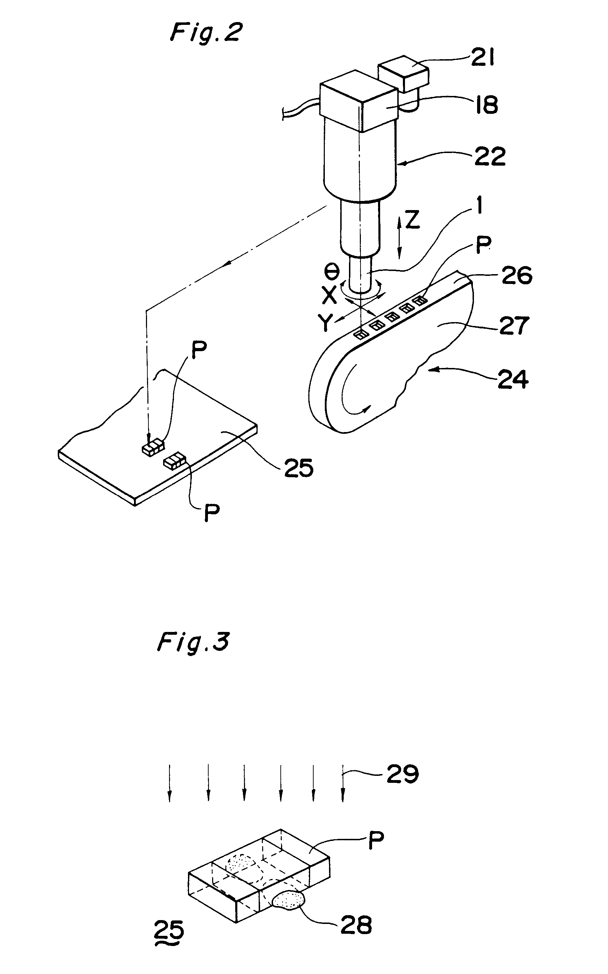

A mounting head 22 of the above-described construction is engaged with a moving table 23 and is constructed to move between the take-up position of a parts feed portion 24 and an optional position, where the electronic parts are to be mounted on the circuit basic plate 25, as shown in Fig. 2. A parts cassette 27 with an electronic parts tape 26 being set thereinto is disposed in the parts feed portion 24. The electronic parts tape carries a plurality of electronic parts P. The electronics parts P are adapted to be sequentially fed into the mounting position.

The operation will be described hereinafter. At first, the mounting head 22 is oppositely positioned above the take-up position of the parts feed portion 24 so as to recognize the shape of the electronic parts P of the mounting position by the recognition means or camera 18 through the suction nozzle 1 and the light transmitting plate 5 made of a light transmitting material. When the electronic parts P are improper in shape, the mounting operation does not take place. The parts cassette 27 is actuated as it is so as to feed the next electronic part P into the mounting position and to recognize the shape thereof again by the recognition camera 18.

When the shape of the electronic part P is proper, a moving table 23 moves down so that the electronic part P is sucked up by the suction nozzle 1 and then rises again. Thereafter, the moving table 23 moves to position above the given apparatus position of the circuit basic plate 25 and the electronic part P is sucked up by the suction nozzle 1. At this time, the recognition camera 18 correctly recognizes the position of the sucked electronic part P so as to detect any eccentric amount in the X - Y direction and the inclination angle ϑ with respect to the engagement posture of the electronic part P. The correction thereof is effected by a correction movement of the moving table 23 and rotation of the pulley 16. Thereafter, the moving table 23 is lowered to correctly mount the electronic part P in the given position of the circuit basic plate 25.

An ultraviolet rays applying apparatus 21 is positioned on the same axial center as the suction nozzle 1. As shown in Fig. 3, ultraviolet rays 29 are applied upon a bonding agent 28 of an ultraviolet rays hardening type partially leaked onto the side portion by the engagement of the electronic part P so as to temporarily secure the electronic part P.

By the repetition of the above-described operation, the proper electronic parts P are efficiently mounted sequentially in the electronic parts mounting position on the circuit basic plate 25 so as to complete the mounting of all the electronic parts P. The circuit basic plate 25 is inserted into the reflowing furnace for the actual fixing operation with solder.

As described hereinabove, according to the present embodiment, the temporary fixing operation may be effected without the movement of the electronic parts.

A second embodiment of the present invention will be described hereinafter. In this embodiment, a laser rays applying apparatus instead of the ultraviolet rays applying apparatus 21 is used.

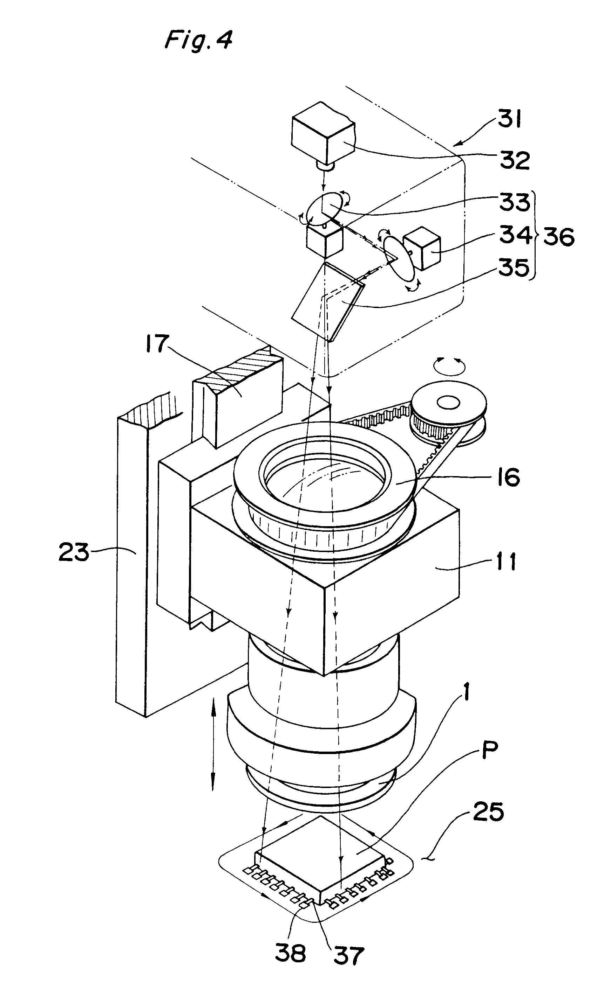

Referring to Fig. 4, a laser rays applying apparatus 31 comprises a laser generator 32, a scanning apparatus 36 composed of an X - galvanometer 33, a Y - galvanometer 34 and a mirror 35 so that the laser rays may be applied along an optional track.

The operation in the embodiment is almost similar to the first embodiment before the electronic parts P are mounted on the circuit basic plate 25. After an electronic part P has been mounted, the laser rays applying apparatus 31 is positioned on the axial center of the suction nozzle 1, the laser generator 32 and the scanning apparatus 36 are operated. The laser rays are sequentially applied onto respective leads 37 of the electronic part P to be connected to the electrode 38 of the circuit basic plate 25 to heat with the laser rays the solder for reflowing use coated on the electrodes 38 for effecting the reflowing operation so as to connect the electrodes 38 with the leads 37 through solder. After the connection of the leads 37 on the full periphery of the electronic part P has been completed, the operation moves into the mounting action of the next electronic part P to repeat the above-described operations.

In this manner, the mounting on the circuit basic plate 25 of the electrode parts P and simultaneously the connection thereof may be effected in this manner.

Although in the embodiment, the bonding agent for temporalily securing the electronic parts P is not required to be applied upon the circuit basic plate 25, the bonding agent may be kept on it.

As described hereinabove, according to the present embodiment, the solder for the reflowing use applied upon the electrode through the sequential application of the laser rays on respective leads, with the the lead of the electrode parts being in contact on the electrode of the circuit basic plate during the engagement of the electronic parts, so that the reflowing step at the reflowing furnace may be removed through the connection between the electrode and the lead.

Furthermore, the rays applying means and the recognizing means are jointly disposed to selectively position on the axial center of the suction nozzle to detect by the recognition means the position of the electronic parts taken up in the parts feed portion. After the correct mounting in the given position of the circuit basic plate through the correction of positional slip, the recognition means is switched into the rays applying means so that the above-described operation may be effected immediately with respect to the mounted electrode parts.

A third embodiment of the present invention will be described hereinafter. The present embodiment is characterized in that the inputting operation of the parts data in the parts feed portion may be effected automatically, also wrong types of parts if fed may be effectively used without being disused.

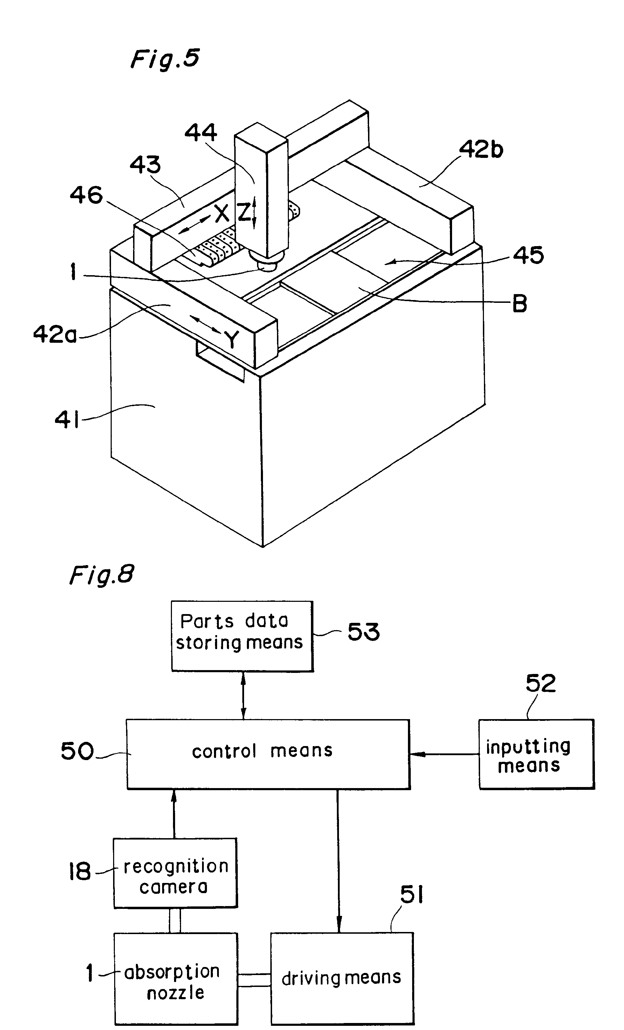

Referring to Fig. 5, a pair of right, left Y-axis tables 42a, 42b are disposed on the top portion of a main body frame 41, with a X-axis table 43 being movable in the Y-direction thereon. Furthermore, a Z-axis table 44 is disposed movably in the X-direction along the X-axis table 43, with a mounting head ( not shown, see Fig. 4 ) having the suction nozzle 1 built-in in the Z-axis table 44 for its free movement in the Z-direction. Also, a carrier positioning means 45 of the circuit basic plate B for engaging the electronic parts P is disposed in the front portion of the top face of a main body frame 41 and a parts feed portion 46 is disposed in the rear portion thereof, so that the suction nozzle 1 is adapted to move between the mounting position of the parts feed portion 46 and an optional position, where the electronic parts P on the circuit basic plate B should be engaged with.

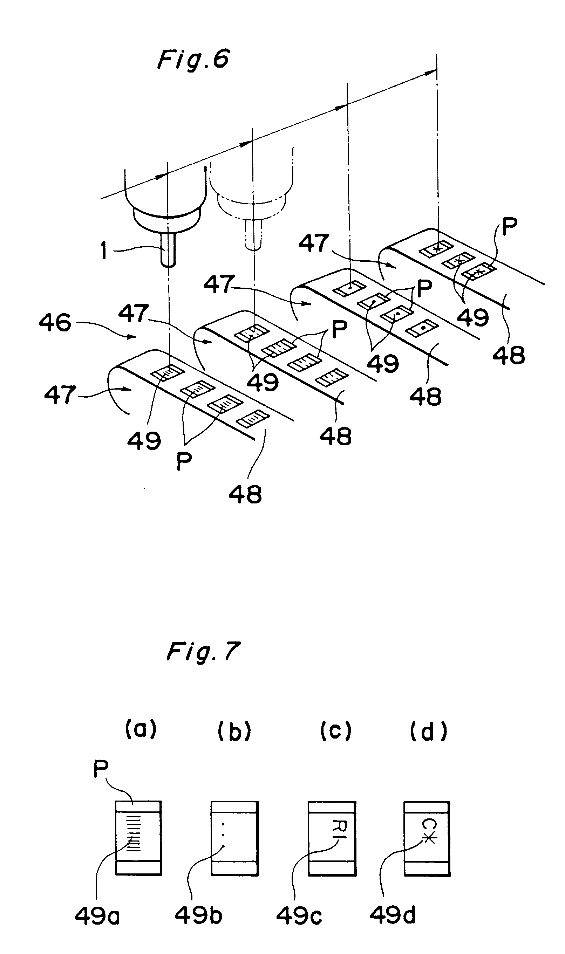

As shown in Fig. 6, electronic parts tapes 48 each having a plurality of electronic parts P accommodated in one row in the tape-shaped member are engaged with the parts feed portion 46. A plurality of parts feed cassettes 47 are disposed in parallel so that the electronic parts tapes 48 may be fed towards the mounting position one pitch by one pitch through the arrangement pitch of the electronic parts P. Also, the electronic parts P accommodated in the respective electronic parts tapes 48 are respectively of the same type, with the respective electronic parts P having marks 49 thereon to show the types.

As shown in Fig. 7 (a), (b), (c), (d), there are adopted optional types of marks, as marks 49, for example, symbols easy to be binary-coded such as bar codes 49a, dot codes 49b, etc., letters 49c, combinations 49d of the letters and the respective symbols or the like.

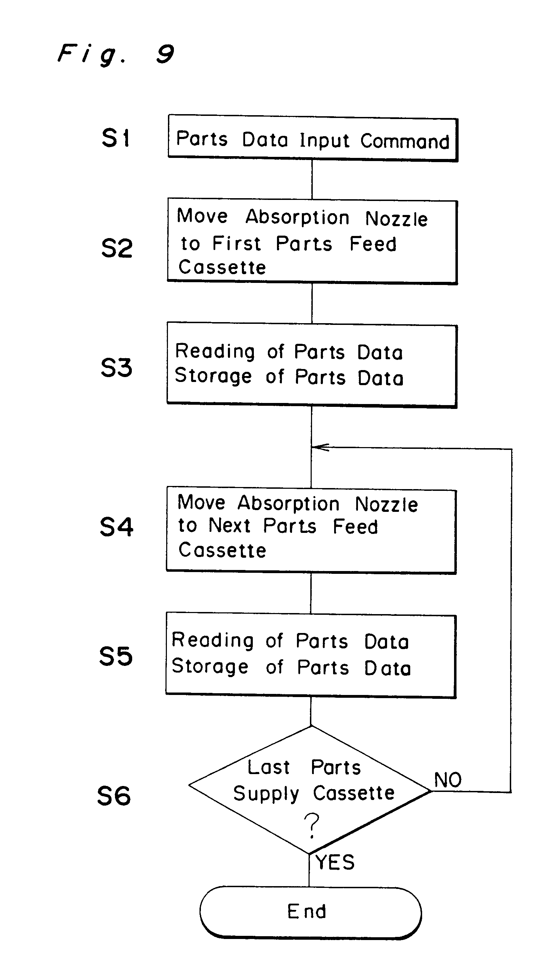

As shown in Fig. 8, the suction nozzle 1 is driven by a driving means 51 such as a motor each disposed on the Y-axis, X-axis, Z-axis tables 42a, 42b, 43, 44 to be controlled by a control means 50. The signals are inputted from an input means 52 and a recognition means or camera 18 into the control means 50. A parts data storing means 53 for storing the arrangement condition of the electronic parts in the parts feed portion 46 is connected with the control means 50.

The operation will be described hereinafter. Prior to the engagement of the electronic parts P, the data on the arrangement condition of the parts in the parts feed portion 46 are inputted with respect to the parts data storing means 53. As shown in Fig. 9, when a parts data input instruction is issued into the control means 50 from the inputting means 52 (S1), the suction nozzle 1 is moved into the parts take up position of a first parts feed cassette 47 (S2) to read the mark 49 of the electronic parts P by the recognition camera 18 for discriminating between the types of the electronic parts P so as to store them on the parts data storing means 53 (S3). As shown in an imaginary line in Fig. 6, the suction nozzle 1 moves into the parts take up position of the next parts feed cassette 47 (4) so as to read the marks 49 of the electronic parts P as described hereinabove for discrimination between the types of the electronic parts P to store them in the parts data storing means 53 (S5). Then, an judgment is made as to whether or not the cassette is the last parts feed cassette 47 (S6). When the cassette is not the last parts feed cassette 47, the step returns to the step S4 to repeat the above-described operations as far as the last parts feed cassette 47 so as to store the types of the electronic parts P about all the parts feed cassettes 47.

The engagement operation of the electronic parts P will be described hereinafter. The arrangement position of the parts feed cassette 47, wherein the electronic parts P of an optional type to be engaged with are accommodated are read from the parts data storing means 53 by the control means 50 so as to position it oppositely above the take up position of the parts feed cassette 47, wherein the suction nozzle 1 is specified by the driving means 51 for recognition of the mark 49 and the shape of the electronic part P through the absorption nozzle 1 and the light transmitting plate 5, each being made of a light transmitting material, by the recognition camera 18. When the electronic part P is improper in type and shape, the operation does not go into the mounting operation, and the next electronic part P is fed as it is into position to recognize the type and shape thereof again by the recognition camera 18. When the type and shape of the electronic part P is proper, the moving table 23 is lowered to absorb the electronic part P by the suction nozzle 1. After it has been raised again, the X-axis table 43 and the Y-axis tables 42a, 42b are operated to position the electronic part P sucked by the suction nozzle 1 above the given mounting position of the circuit basic plate B.

At this time, the position of the electronic part P is recognized correctly by the recognition camera 18 to detect any eccentric amount in the X-direction and the Y-direction, and the inclination angle ϑ with respect to the engagement posture of the electronic part P, and the correction thereof is effected by the correction of the movement amount of the X-axis table 43, the Y-axis tables 42a, 42b, and the rotation of the pulley 16. Thereafter, the electronic part P is correctly mounted in the given position of the circuit basic plate B through the down movement of the moving table 23.

By the repetition of the above-described operation, proper electronic parts P are efficiently mounted sequentially in the electronic parts mounting positions on the circuit basic plate B.

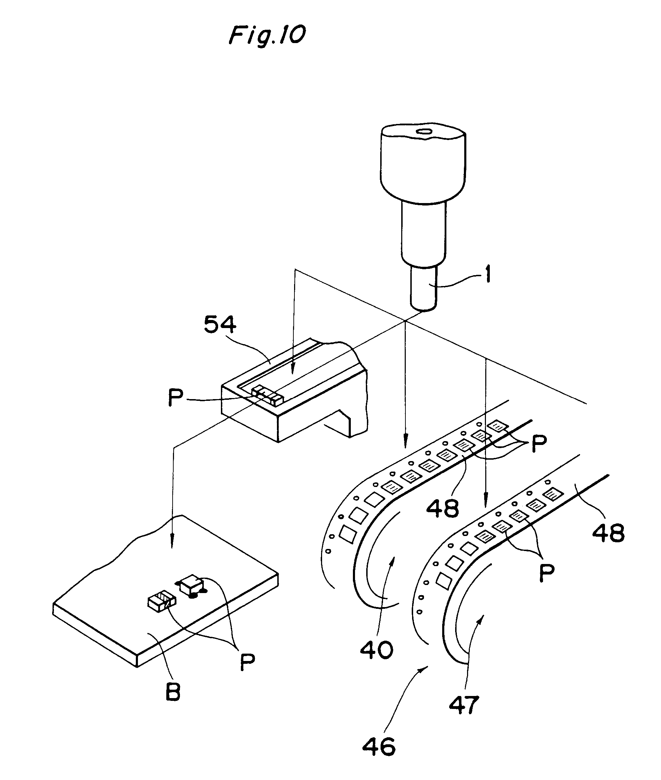

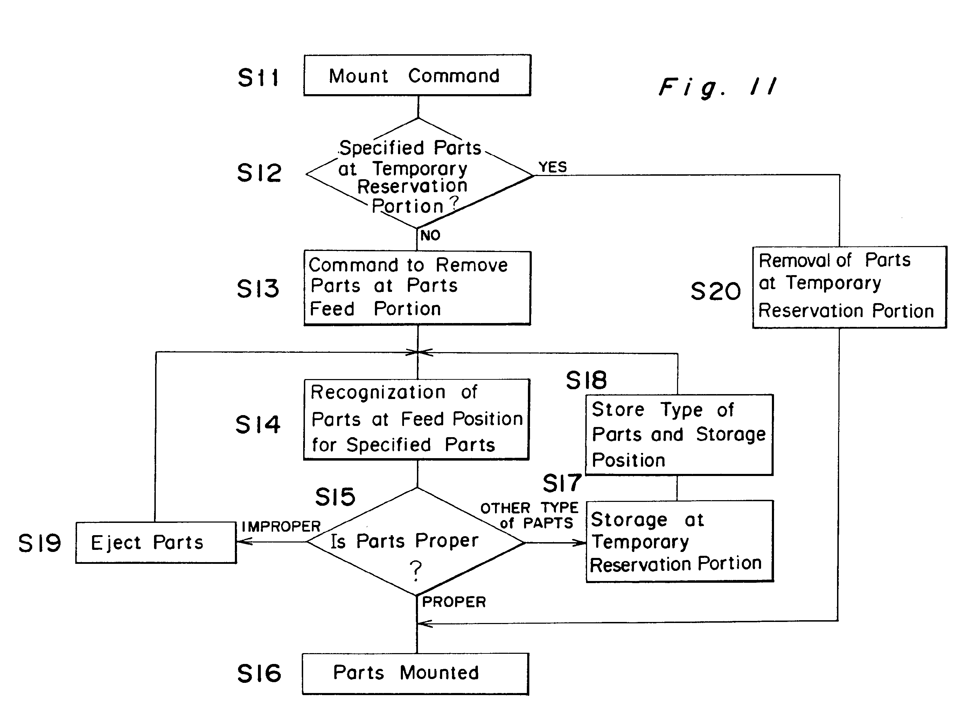

A fourth embodiment of the present invention will be described hereinafter with reference to the Fig. 10 and Fig. 11. As the whole construction of the embodiment is basically the same as that of the above-described embodiment, the description thereof will be quoted. In this embodiment, a temporary reservation portion 54 for temporarily reserving electronic parts is disposed on one side of the arrangement of the parts feed cassette 47 of the parts feed portion 46. Also, when the type of the electronic parts P recognized in the parts feed portion 46 is not a specified type, the control means 50 does not feed the next electronic part P as shown in a third embodiment, and does not disuse the electronic part P fed by error. The parts are absorbed, carried into the temporary reservation portion 54 so that the parts are adapted to be taken out with priority from the temporary reservation portion 54 and to be mounted when an electronic part P of this type is needed.

The details of the mounting operation are shown in Fig. 11. Referring now to Fig. 11, the steps S11 through S16 show the flowing in a case where the specified electronic part P does not exist in the temporary reservation portion 54 and the electronic part P recognized in the parts feed portion 46 are proper. When the type of the electronic part P is different at the step 15, the parts are temporarily kept in the temporary reservation portion 54 and also, the type and the storage position of the electronic parts P are stored at the steps S17, S18.
Thereafter the step returns to the step S14 so as to engage the next electronic part P. When the recognized electronic part P is improper in shape or the like, the electronic part P is not used and the operation returns to step S14. When the type of the specified electronic part P exists in the temporary reservation portion 54 in the judgment of the step S12, the electronic part P is taken out from the temporary reservation portion 54 (step S20) to effect the parts mounting.

Although the fourth embodiment shows an example, in which the electronic parts P are stored in the temporary reservation portion 54 when the type is different through the recognition of the electronic parts P in the parts feed portion 46, the operation program of the control means 50 may be constructed so that the recognized electronic parts P are absorbed as they are by the replacement of the engagement order of the electronic parts P so as to engage the electronic parts P with the position to be engaged with.

According to the present embodiment, the marks of the respective parts are recognized by the recognition means through the suction nozzle when the arrangement data of the respective parts in the parts feed portion are inputted into the storage means so as to store the types of the parts found out on the recognition means, the inputting operation of the arrangement data of the parts may be effected automatically, the effort and time of inputting the data may be saved, and also, troubles caused by inputting errors may be removed.

When the recognized parts are different from the specified parts at the engagement of the parts, the parts are carried into the temporary reservation portion so as to effect mounting with priority from the temporary reservation portion or replace the mounting order of the parts at the time of mounting the parts of the type in the correct position. Therefore, the parts if fed by mistake are not wasted through the disuse thereof, with large effects in the case of the parts of higher functions and high values.

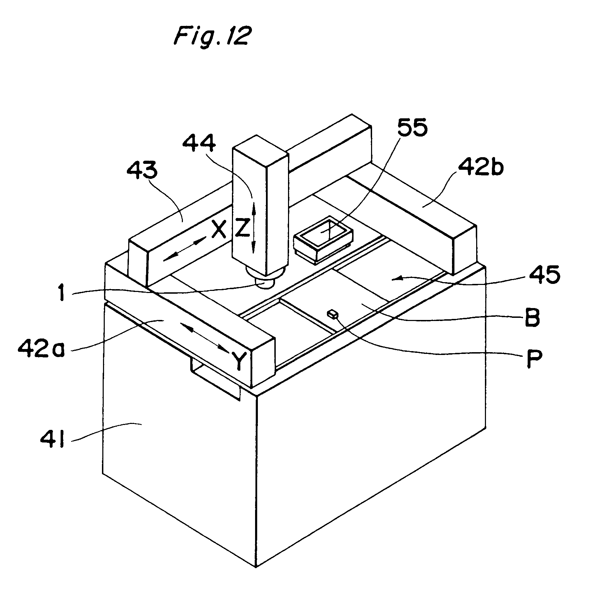

A fifth embodiment of the present invention will be described hereinafter. This embodiment is characterized in that dust or filth of the suction nozzle 1 and the light transmitting plate 5, each made of a light transmitting material, is removed to prevent the recognition errors. The difference between Fig. 12 and Fig. 5 is that an ultrasonic wave washing cell 55 is disposed in Fig. 12.

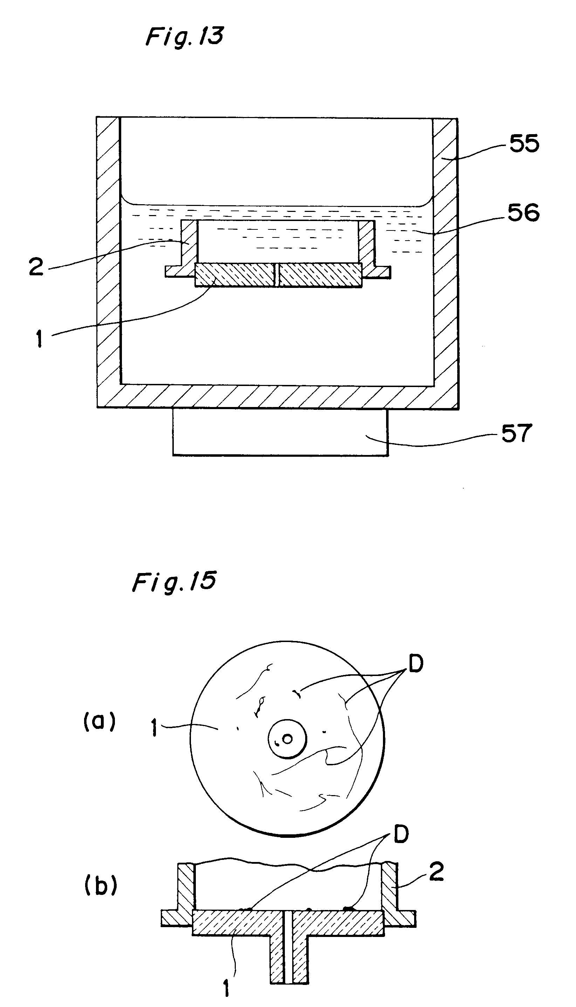

As shown in Fig. 13, the ultrasonic wave washing cell 55 has a washing liquid 56 inside, an ultrasonic wave generator 57 mounted on its bottom face. The suction nozzle 1 together with the nozzle holder 2, or the light transmitting plate 5 together with the suction drum 3, is simply dipped in the washing liquid, thus making it possible to wash the suction nozzle 1 and the light transmitting plate 5.

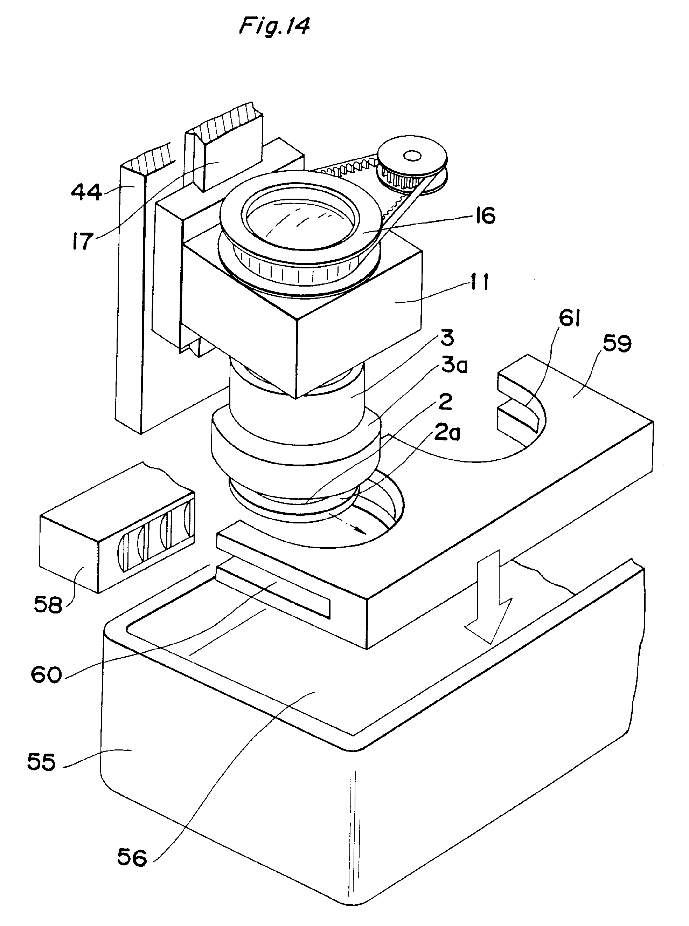

Also, a drying means 58 for blowing hot blast upon the nozzle holder 2 and the suction drum 3, picked up from within the washing cell 55, so as to dry them is disposed near the ultrasonic wave washing cell 55 as shown in Fig. 14. Furthermore, there is additionally provided an operating means 59 for automatically washing the suction nozzle 1 and the light transmitting plate 5. The operating means 59 may move up and down by a driving means not shown between a position where they are dipped into the washing liquid 56 within the washing cell 55 and a position where they are raised upwards. An engagement supporting brim 2a projecting from the outer periphery of the nozzle holder 2 and an engagement supporting brim 3a projecting from the outer periphery of the suction drum 3 may be inserted from the horizontal direction. On the inserting condition, engagement portions 60, 61 for retaining through the engagement in the vertical direction are formed. The nozzle holder 2 and the suction drum 3 may be engaged with or disengaged from with respect to the operation means by the rising, falling of the moving table 23, with the engagement supporting brim 2a of the nozzle holder 2 or the engagement supporting brim 3a of the suction drum 3 being engaged with the engagement portion 60 or 61.

During the suction of electronic parts P, dust D or the like, together with the suction air-current is admitted into the suction chamber. When dusts D rests on the suction nozzle 1 or the light transmitting plate 5 as shown in Fig. 15 (a), (b), it is detected by the recognition camera 18. Therefore, an operation program is made so that the dusts of the suction nozzle 1 and the light transmitting plate 5 may be detected by the recognition camera 18 for each or for each number of mounting operations. As the dust or filth detecting system, there is a step of, for example, positioning the suction nozzle 1 on an illumination member or a white pattern to recognize it by the recognition camera 18 to detect dust or filth, with the number of the picture elements, when the level becomes dark because of dust, being more than a constant number.

If dust or filth on the suction nozzle 1 or the light transmitting plate 5 is detected, a washing operation instruction is transmitted so as to move the mounting head towards the ultrasonic wave washing cell 55. After the supporting brim 2a of the nozzle holder 2 has been inserted into the engagement portion 60 of the operation means 59 from the horizontal direction, the moving table 23 is raised to cause the nozzle holder 2 to engage with the operation means 59. Similarly, the supporting brim 3a of the suction drum 3 is retained through engagement with the engagement portion 61 of the operation means 59. Thereafter, an alternate suction drum 3 and nozzle holder 2 are mounted on the mounting head so as to be restored into the engagement operation.

The nozzle holder 2 and the suction drum 3 retained through the engagement with the operation means 59 are dipped into the washing liquid 56 of the washing cell 55 by downward movement of the operation means 59, and the suction nozzle 1 and the light transmitting plate 5 are washed. After the washing operation of a certain time period, the operation means 59 is raised to pick up them from the washing cell 55, so that they are dried with the hot blast from the drying means 58. After the completion of the washing and drying operations, they are kept waiting as they are. These suction drum 3 and nozzle holder 2 are mounted on the mounting head through the action opposite to the above-described action at the proper time so as to be restored into the engagement operation of the parts again.

In addition to the washing operation through the detection of filth as described hereinabove, the washing operation may be effected periodically at such intervals in which filth normally may not be caused.

In the above-described embodiment, the ultrasonic wave washing cell is used as the washing means, but other washing means may be used. In the above-described embodiment, in the mounting head provided with the suction nozzle and the light transmitting plate, an example is shown, wherein both the nozzle and the plate are simultaneously washed. When only either one of them is dirty, only one need be washed. Also, in the case of the mounting head provided with the suction nozzle only, naturally only this need be washed.

As is clear from the foregoing description, according to the arrangement of the present invention, when the suction nozzle and the light plate become dirty, the filth may be detected or they may be washed periodically before they become dirty, by the additional washing means such as ultrasonic wave washing cell or the like. Thus, recognition errors may be prevented.

Also, when an ultrasonic wave washing cell is used as a washing means, a higher washing degree may be easily obtained.

Also, by the provision of a drying means, the suction nozzle and the light transmitting plate may be put into a condition to be used in a short time after the washing operation thereof.

Furthermore, the washing means is disposed within a movable range of the suction nozzle, and also, the operation means, which moves between the upper position of the washing cell and the washing cell interior, with the suction nozzle and the light transmitting plate being engaged, is provided to make it possible to effect an automatic washing operation.

Also, the recognition means for recognizing the parts to be mounted is also used to detect the dust or filth, to effect the washing operation. Wasteful washing operations are avoided, thus retaining a higher rate of operation.

A periodical washing operation has the advantage that the control operation is simplified.

## Claims

1. An electronic parts mounting head (22) comprising
a suction nozzle (1) made of light transmitting material for holding an electronic part (P),
a recognition means (18) including a first light ray applying means (20) for applying light rays through the suction nozzle (1) for recognizing the electronic part (P) through the suction nozzle (1),
characterized by
a second light ray applying means (21, 31) which is adapted to be selectively positioned at the mounting head (22) for securing the electronic part (P) sucked to the suction nozzle (1) to a circuit base plate (25).

2. A mounting head according to claim 1,
characterized in that the recognition means (18) including the first light ray applying means (20) and the second light ray applying means (21, 31) are selectively positioned on the axial centre of the suction nozzle (1).

3. A mounting head according to claim 1 or 2,
characterized in that the second light ray applying means (21) are ultraviolet ray applying means which harden a bonding agent (28) used for temporary securing the electronic part (P) to the circuit base plate (25).

4. A mounting head according to claim 1 or 2,
characterized in that the second light ray applying means (31) are laser light applying means which are directed to the leads (37) of the electronic part (P) for heating solder which secures the leads (37) to electrodes (38) on the circuit base plate (25).

5. A mounting head according to claim 4,
characterized in that the laser light applying means (31) are adapted to direct the laser beam sequentially to the leads (37), one after another.

6. An electronic parts mounting apparatus comprising an electronic part mounting head (22) according to any of claims 1-5, and a parts feed portion (24; 46) having a plurality of parts feed means (26, 27; 47, 48),
characterized by the parts feed portion (24; 46) being adapted to feed different types of parts carrying identification marks (49) to be identified by the recognition means (18) of the suction nozzle (1),
a parts data storing means (53) for storing the types and positions of the recognized parts (P) of the respective parts feed means (26, 27; 47, 48),
a control means (50) for controlling the storage of these type and position data of the recognized parts (P) in the storage means (53).

7. An apparatus as claimed in claim 6,
characterized by a temporary reservation portion (54) for receiving parts (P), to be mounted later with priority, from the respective parts feed means (26, 27; 47, 48) when it has been found by the recognizing means (18) upon checking the marks (49) that the parts (P) are different in type from the parts data obtained from the storage means (53).

8. An apparatus as claimed in claim 6,
characterized in that the control means (50) are adapted to change the mounting order of parts (P) when it was found out that the parts (P) recognized by the recognition means (18) are of different type from the parts data obtained from the storage means (53).

9. An electronic parts mounting apparatus comprising an electronic parts mounting head (22) according to any of claims 1-5,
characterized by washing means (55) for washing the suction nozzle (1), or a light transmitting plate (5) of it, of the mounting head (22) from dust etc. which would interefere the function of the recognizing means (18).

10. An apparatus as claimed in claim 9,
characterized in that the washing means comprises an ultrasonic washing cell (55).

11. An apparatus as claimed in claim 9 or 10,
characterized by drying means (58) for drying the suction nozzle (1) after removal from the washing means (55).

12. An apparatus as claimed in any of claims 9-11,
characterized by operation means (59) within the reach of the movable suction nozzle (1), for moving the suction nozzle (1), or a light transmitting plate (5) of it, to the washing means (55).

## Patentansprüche

1. Bestückungskopf (22) für elektronische Bauelemente mit einer Saugdüse (1) aus lichtdurchlässigem Material zum Halten eines elektronischen Bauelementes (P),
Erkennungsmitteln (18), die ein erstes Lichtstrahlen aussendendes Mittel (20) zum Aussenden von Lichtstrahlen durch die Saugdüse (1) zum Erkennen des elektronischen Bauelementes (P) durch die Saugdüse (1) enthalten,
gekennzeichnet durch
ein zweites Lichtstrahlen aussendendes Mittel (21, 31), das so ausgelegt ist, daß es zum befestigen des an der Saugdüse (1) durch Saugen gehalterten elektronischen Bauelementes (P) an einer Schaltungsplatine (25) nach Wahl positioniert werden kann.

2. Bestückungskopf nach Anspruch 1,
dadurch gekennzeichnet, daß die Erkennungsmittel (18) einschließlich der ersten Lichtstrahlen aussendenden Mittel (20) sowie der zweiten Lichtstrahlen aussendenden Mittel (21, 31)nach Wahl auf der axialen Mitte der Saugdüse (1) positionierbar sind.

3. Bestückungskopf nach Anspruch 1 oder 2,
dadurch gekennzeichnet, daß die zweiten Lichtstrahlen aussendenden Mittel (21) ultraviolette Strahlen aussenden, die ein Haftmittel (28) zum vorläufigen Befestigen des elektronischen Bauelementes (P) an der Schaltungsplatine (25) härten.

4. Bestückungskopf nach Anspruch 1 oder 2,
dadurch gekennzeichnet, daß die zweiten Lichstrahlen aussendenden Mittel (31) Laserstrahlen aussenden, die auf die Leitungen (37) des elektronischen Bauelementes (P) zum Erwärmen des Lötzinns gerichtet sind, um die Leitungen (37) an den Elektroden (38) der Schaltungsplatine (25) zu befestigen.

5. Bestückungskopf nach Anspruch 4,
dadurch gekennzeichnet, daß die Laserstrahlen aussendenden Mittel (31) so ausgelegt sind, daß sie den Laserstrahl sequentiell auf eine Leitung nach der anderen der Leitungen (37) richten.

6. Bestückungsgerät mit einem Bestückungskopf (22) für elektronische Bauelemente nach einem der Ansprüche 1 bis 5 und einem Zuführabschnitt (24; 46) für Bauelemente, der eine Mehrzahl von Bauelementezuführmitteln (26, 27; 47, 48) aufweist,
dadurch gekennzeichnet, daß der Zuführabschnitt (24; 46) für Bauelemente so ausgelegt ist, daß er unterschiedliche Arten von Bauelementen zuführen kann, die mit Erkennungsmarkierungen (49) zur Identifikation durch die Erkennungsmittel (18) der Saugdüse (1) versehen sind,
daß ein Bauelementedatenspeicher (53) zum Speichern von Type und Position der identifizierten Bauelemente (P) der entsprechenden Zuführmittel (26, 27; 47, 48) für Bauelemente vorgesehen ist,
daß eine Steuereinrichtung (50) zum Steuern der Speicherung dieser Typen- und Positionsdaten der identifizierten Bauelemente (P) im Speicher (53) vorgesehen ist.

7. Gerät nach Anspruch 6,
dadurch gekennzeichnet, daß ein Rückhalteabschnitt (54) für eine zeitlich begrenzte Aufnahme von den jeweiligen Bauelementezuführmitteln (26, 27; 47, 48) für später vorrangig auf der Schaltungsplatine anzubringenden Bauelementen (P) vorgesehen ist, bei denen die Erkennungsmittel (18) nach Überprüfung der Markierungen (49) feststellen, daß die Type der Bauelemente (P) von den Bauelementedaten abweicht, die der Speicher (53) ausgegeben hat.

8. Gerät nach Anspruch 6,
dadurch gekennzeichnet, daß die Steuereinrichtung (50) so ausgelegt ist, daß sie die Reihenfolge der Bestückung mit Bauelementen (P) verändern kann, wenn festgestellt wird, daß die von den Erkennungsmitteln (18) identifizierten Bauelemente (P) nicht der Type entsprechen, deren Daten der Speicher (53) ausgegeben hat.

9. Bestückungsgerät mit einem Bestückungskopf (22) für elektronische Bauelemente nach einem der Ansprüche 1 bis 5,
gekennzeichnet durch Wascheinrichtungen (55) zum Abwaschen von Staub oder dergleichen von der Saugdüse (1) oder einer dazugehörenden lichtdurchlässigen Platte (5) des Bestückungskopfes (22), der die Funktion der Erkennungsmittel (18) beeinträchtigen würde.

10. Vorrichtung nach Anspruch 9,
dadurch gekennzeichnet, daß die Wascheinrichtung eine UltraschallReinigungszelle (55) enthält.

11. Vorrichtung nach Anspruch 9 oder 10,
gekennzeichnet durch Trocknungsmittel (58) zum Trocknen der Saugdüse (1) nach dem Entfernen aus der Wascheinrichtung (55).

12. Vorrichtung nach einem der Ansprüche 9 bis 11,
gekennzeichnet durch Betätigungsmittel (59) in Reichweite der bewegbaren Saugdüse (1) zum Bewegen der Saugdüse (1) oder einer lichtdurchlässigen Platte (5) der Saugdüse zu der Wascheinrichtung (55).

## Revendications

1. Tête de montage de composants électroniques (22), comprenant :
une buse d'aspiration (1), réalisée en un matériau transmettant la lumière, pour maintenir un composant électronique (P),
un moyen de reconnaissance (18), comprenant un premier moyen d'application de rayon lumineux (20), pour appliquer des rayons lumineux devant passer à travers la buse d'aspiration (1), en vue de reconnaître le composant électronique (P) en explorant à travers la buse d'aspiration (1),
caractérisé par
un deuxième moyen d'application de rayon lumineux (21, 31), adapté pour être positionné sélectivement sur la tête de montage (22), de manière à fixer le composant électronique (P) ayant été aspiré sur la buse d'aspiration (1) sur une plaque de base de circuit (25).

2. Tête de montage selon la revendication 1, caractérisée en ce que le moyen de reconnaissance (18), comprenant le premier moyen d'application de rayon lumineux (20), et le deuxième moyen d'application de rayon lumineux (21, 31), sont positionnés sélectivement au centre axial de la buse d'aspiration (1).

3. Tête de montage selon la revendication 1 ou 2, caractérisée en ce que le deuxième moyen d'application de rayon lumineux (21) est un moyen d'application de rayons ultraviolet faisant durcir un agent de liaison (28) utilisé pour fixer temporairement le composant électronique (P) à la plaque de base de circuit (25).

4. Tête de montage selon la revendication 1 ou 2, caractérisée en ce que le deuxième moyen d'application de rayon lumineux (31) est un moyen d'application de lumière laser, orienté vers les conducteurs (37) du composant électronique (P) pour chauffer une brasure fixant les conducteurs (37) aux électrodes (38) sur la plaque de base de circuit (25).

5. Tête de montage selon la revendication 4, caractérisée en ce que le moyen d'application de lumière laser (31) est adapté pour diriger le faisceau laser séquentiellement sur les conducteurs (37), l'un après l'autre.

6. Appareil de montage de composants électroniques, comprenant une tête de montage de composants électroniques (22) selon l'une des revendications 1 à 5, et une partie d'alimentation en composants (26: 46), équipée d'une pluralité de moyens d'alimentation (26, 27; 47, 48)
caractérisé par le fait que
la partie d'alimentation en composants (26; 46) est adaptée pour alimenter en différents types de composants, portant des marquages d'identification (49), devant être identifiés par le moyen de reconnaissance (18) de la buse d'aspiration (1),
un moyen de mémorisation de données composants (53) est prévu pour mémoriser les types et les positions des composants (P) identifiés des moyens d'alimentation en composants (26, 27; 47, 48) respectifs,
un moyen de commande (50) est prévu pour commander la mémorisation de ces données de types et de position des composants (P) identifiés, dans le moyen de mémoire (53).

7. Appareil selon la revendication 6, caractérisé par une partie de réservation temporaire (54), destinée à recevoir des composants (P) à monter ultérieurement, avec indication de priorité, par les moyens d'alimentation en composants (26, 27; 47, 48) respectifs, lorsqu'il a été apprécié, par le moyen de reconnaissance (18) ayant appréhendé les marquages (49) que les composants (P) sont de type différents par rapport aux données composants obtenues du moyen de mémorisation (53).

8. Appareil selon la revendication 6, caractérisé en ce que le moyen de commande (50) est adapté pour modifier l'ordre de montage des composants (P), lorsqu'il a été jugé que les composants (P) identifiés par le moyen de reconnaissance (18) sont de type différent par rapport aux données composants obtenues du moyen de mémorisation (53).

9. Appareil de montage de composants électroniques, comprenant une tête de montage de composants électroniques (22) selon l'une des revendications 1 à 5, caractérisé par le fait qu'il comprend des moyens de lavage (55), pour laver la buse d'aspiration (1), ou une plaque de transmission de lumière (5) appartenant à la buse d'aspiration de la tête de montage (22), pour la débarrasser de la poussière, etc., pouvant interférer avec le fonctionnement du moyen de reconnaissance (18.

10. Appareil selon la revendication 9, caractérisé en ce que le moyen de lavage comprend une cellule de lavage aux ultrasons (55).

11. Appareil selon la revendication 9 ou 10, caractérisé en ce qu'il comprend un moyen de séchage (58), pour sécher la buse d'aspiration (1), après qu'elle ait quitté le moyen de lavage (55).

12. Appareil selon l'une quelconque des revendications 9 à 11, caractérisé en ce qu'il comprend un moyen d'actionnement (59), situé à portée de la buse d'aspiration (1) mobile, pour déplacer la buse d'aspiration (1), ou une plaque de transmission de la lumière (5) de la buse d'aspiration, vers le moyen de lavage (55).
